# EUROPEAN PATENT APPLICATION

(11) **EP 4 650 891 A1**
(43) Date of publication of application: **19.11.2025**
(21) Application number: 24176525.4
(22) Date of filing: 17.05.2024
(51) Int. Cl.: G05B 19/042

(54) **AUTOMATION DEVICE WITH INTEGRATED DISPLAY UNIT**

(71) Applicant: ABB Schweiz AG, 5400 Baden (CH)
(72) Inventor: Lagler, Christoph, 5142 Eggelsberg (AT)
(74) Representative: Patentanwälte Pinter & Weiss OG

(57) **Abstract**

To ensure a cost-efficient, energy-saving and reliable display of device information (DAT) a display unit (2) of an automation device (1), an automation device (1) is proposed, which comprises a display unit (2), which is set up to display device information (DAT) transferred via the data interface (3), and which is furthermore set up to maintain a currently displayed device information (DAT) as a remanent image, when the power supply of the automation device (1) is turned off and/or fails.

## Description

### TECHNICAL FIELD OF THE INVENTION

The present invention relates generally to the field of industrial automation systems. In particular, the invention relates to an automation device comprising a display unit for visually displaying device information of the automation device, wherein the display unit is connected to a processing unit of the automation device via a data interface to transfer the device information to be displayed to the display unit.

### BACKGROUND INFORMATION

Automation devices are devices used in automation systems or in industrial systems, e.g., for controlling industrial electromechanical processes and/or making operational decisions for a system, with which the respective automation device is connected. Usually, an automation device is equipped with hardware, for example a processing unit (e.g., controller, microcontroller, microprocessor, etc.), and a respective software or firmware to perform data processing required to carry out specific automation tasks.

It is also quite common that an automation device comprises a digital display unit, which in particular could be designed as an integrated display unit. The display unit usually provides a user with important device information (e.g. parameter settings, status information, error information, etc.) during start-up phase and/or normal operation. When the automation device gets powered up, for example, the automation device runs through a start-up phase, before reaching normal operation. During these two phases of operation, important device information, like boot state, pending errors, current parameter settings, current status, etc. can be visually displayed to the user.

The display unit can be connected to the processing unit of the automation device via a data interface. The data interface is used to transfer the device information to be displayed to the display unit and to control displaying the device information on the display unit, thus making the device information available to the user. The provided device information may help the user during commissioning and/or maintenance of the respective automation device and/or an automation system as well as during normal operation or even if a standard communication interface (e.g. a fieldbus connection) is not working due to failure, for example.

As the display unit should normally have a compact, space-saving and flat design, either liquid-crystal displays (short: LCD) or organic light-emitting diode displays (short: OLED displays) are used for the digital display unit of the automation device. LCD uses the light-modulating properties of liquid crystals combined with polarizers. Since the liquid crystals do not emit light directly, a backlight or reflector is used to produce images in color or monochrome. A display unit based on OLED technology uses a type of light-emitting diode, in which the emissive electroluminescent layer is an organic compound film (e.g., small molecules, polymers, etc.), that is situated between two electrodes and emits light in response to an electric current. OLED therefore works without a backlight. Both display types - LCD and OLED - have the disadvantage that they need a power supply or voltage supply to work. I.e., if the automation device and thus the integrated display unit are not or no longer supplied with power e.g., due to a shutdown of the automation device or system during installation and/or commissioning, by activating the kill switch or due to a power failure in the automation system, etc., the display unit usually gets dark. The device information shown on the display unit vanishes and gets lost without any possibility to recover that information (e.g., status, information on the last errors occurred, etc.) at least partially. Thus, the user is deprived of the opportunity to use this device information, e.g. for commissioning purposes, for troubleshooting, for analysis of failure, etc.

One quite obvious way of keeping the last-shown device information displayed on the display unit would be to use a battery buffered concept. I.e., either the display unit or the automation device is equipped with a battery which ensures that the display unit can continue to display the device information shown at last before turning-off or the loss of power supply. But a battery buffered concept, in particular equipping the display unit with a battery, would lead to additional costs. On the one hand, battery operation of the display unit or even the automation device would require regular charging and/or replacement of the battery, which generates considerable maintenance costs. On the other hand, the display unit would also have to be equipped with a memory unit to store the device information to be displayed and a controller to control the display of the device information while the turn-off or loss of power supply. Furthermore, it is also uncertain how long the device information would remain on the display unit during battery supply and thus would be available to the user.

### SUMMARY

The objective of the present disclosure is to provide an automation device with a display unit which reduces or overcomes the disadvantages of the prior art and which provides a reliable and cost-efficient way to display device information on the display unit even during a shutdown and/or a loss of power supply.

These and other objectives are solved by an automation device according to the independent claim. Advantageous embodiments of the present invention are described by the dependent claims.

According to the invention, these and other objectives are achieved by an automation device with a display unit for visually displaying device information of the automation device, the display unit being connected via a data interface to a processing unit of the automation device, wherein the device information to be displayed on the display unit is transferred via the data interface to the display unit. The display unit is set up to display device information transferred via the data interface. When the power supply of the automation device is turned off and/or fails, the display unit is furthermore set up to maintain a currently displayed device information (i.e., the device information at last displayed before the turn-off and/or fail of the power supply) as a remanent image.

The main aspect of the present invention is that the device information can be shown on the display unit in case of a turn-off and/or failure of the power supply. The device information may thus be still available to the user, when the power supply is turned off or fails, , because this device information is frozen on the display unit displaying it as a remanent image. This may simplify commissioning, maintenance and in particular troubleshooting tremendously, because a user like a service technician, for example, is now provided with important device information on the display unit of the automation device, even without an existing power supply, and can identify the respective automation device in error state and/or an occurred error leading to a power failure or malfunction, for example.

In a preferred embodiment of the automation device the display unit of the automation device uses electronic paper technology for displaying the device information. Electronic paper, also known as E-paper or electronic ink (E-ink) or intelligent paper, is a display technology that mimics the appearance of ink on paper. Unlike conventional flat panel displays (e.g., LCD) that emit light, an electronic paper display reflects ambient light, like paper. Electronic paper comprises various display technologies that are based on the different reflectivity of the display surface. Texts and/or images displayed can be changed using electrical power. The displayed texts and/or images can then be displayed without the need of a power supply for a very long time or even permanently. E-paper display technology may include, for example, such display technologies as Gyricon, electrophoretics (i.e., forming images by rearranging charged pigment particles with an applied electric field), electrowetting (i.e., that the image is created based on controlling the shape of a confided water/oil interface by an applied voltage), interferometry (i.e., using an electrically switched light modulator), and plasmonics (i.e., using plasmonic nanostructures with conductive polymers).

Ideally, the display unit is set up to transfer and/or display the device information during an existing power supply of the automation device. It is especially advantageous, when the display unit is set up to update the displayed device information cyclically to ensure that the information displayed it constantly updated and that always the latest information is displayed on the display unit, when the power supply is turned off and/or fails.

Furthermore, it is quite convenient, if the display unit is set up to maintain the displayed device information as a remanent image, at least until the power supply of the automation device is restored again. New device information may then be transferred via the data interface to the display unit to be displayed, but it is also possible to keep the remanent image of the device information displayed, even longer and e.g., trigger an update of the device information manually.

Ideally, the automation device comprises a housing, wherein the display unit is integrated into a wall of the housing, especially into a window formed in the wall of the housing. Alternatively, the display unit can either be arranged on a wall of the housing or in a window formed in a wall of the housing. This enables a space-saving and flexible design of the automation device, which is particularly important, when the automation device is installed in a cabinet.

It is also advantageous, when the automation device is an automation device with a fieldbus connection, like e.g. a servo drive, a servo amplifier, an inverter, etc. The device information displayed on the display unit may then at least comprise a fieldbus address (e.g., Powerlink node number, etc.) in any state - i.e., with or without an existing power supply of the automation device. This is especially helpful, when dynamic node allocation (short: DNA) is used for assigning the fieldbus address. The DNA functionality (e.g., in POWERLINK) may be used to set the node number of a node (i.e., an automation device) from a managing node (e.g., an Industrial PC or a programmable logic controller (PLC)) internally over the network within an automation system.

Furthermore, it is quite convenient, if the device information displayed on the display unit also comprises a current status of the automation device and/or a firmware version of the automation device. The automation device may be turned on and powered during a test phase (e.g. end of the line testing at the production site) for the first time, wherein the data interface between the processing unit of the automation device and the display unit can be initialized during the first startup. Device information of the automation device, in particular the fieldbus address, the current firmware version, etc., can be transferred to the display unit and displayed. When the power supply is turned off, for example, after testing, the currently displayed device information is maintained on the display unit and can be used by a user or service technician, when unboxing the automation device during installation and commissioning at the customer site.

It is also very helpful, when the device information displayed on the display unit comprises an information on errors occurred at last before a power failure. If this information is displayed on the display unit of the automation device, in particular after a power failure or a shutdown due to the kill switch has been hit, the troubleshooting will be improved and simplified. Consequently, the downtime of the automation device and maybe of the whole automation system will be reduced.

### BRIEF DESCRIPTION OF THE DRAWINGS

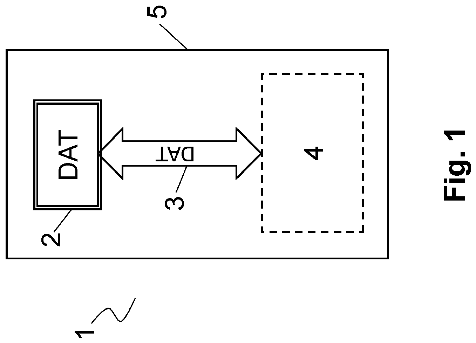

The present invention is described below in greater detail with reference to Figure 1, which shows schematic and non-limiting advantageous embodiment of the invention by way of example. In the drawings:
Fig. 1 shows a block diagram of an automation device with a display unit according to the invention;

### DETAILED DESCRIPTION

Figure 1 shows schematically an exemplary embodiment of the automation device 1 according to the invention. The automation device 1 comprises a processing unit 4 apart from other components (e.g., memory unit, peripheral interfaces circuits, etc.). The processing unit 4 may be a controller, a microcontroller or microprocessor, which may be designed as an embedded system. The automation device 1 may also comprise a housing 5, with which the automation device 1 can be mounted in a cabinet. The automation device 1 may also be an automation device 1 having a fieldbus connection for communicating with other automation devices, sensors and/or actuators of an automation system.

Furthermore, the automation device 1 comprises a digital and electronic display unit 2 for visually displaying device information DAT of the automation device 1. The device information DAT, which can be displayed on the display unit 2, may comprises parameter settings, status of the automation device, error information, a firmware running on the automation device 1, etc. If the automation device 1 has a fieldbus connection, the device information DAT may also comprise a fieldbus address of the automation device 1.

The display unit 2 is integrated into the automation device 1, in particular into a window in a wall of the housing 5 - as exemplary shown in Figure 1. The window, into which the display unit 2 is integrated, may be formed in a front side or a top side of the housing 5 of the automation device 1, for example - depending on the mounting position of the automation device 1. The display unit 2 may be directly connected to the processing unit 4 of the automation device 1 via a data interface 3. The processing unit 4 and the display unit 2 may thus form a single unit, to be built into the automation device 1.

Alternatively, it is also possible that the display unit 2 may be arranged on one side wall of the housing 5 of the automation device 1. E.g., the display unit 2 can be plugged onto the automation unit 1 or into a window formed in a wall of the housing 5. In the case, a corresponding connector may be provided in the housing 5, into which the display unit 2 is plugged and via which a corresponding data interface 3 to the processing unit 4 is established.

The data interface 3 may be designed as serial peripheral interface (SPI), for example, or any other interface, which may be used for short-distance wired communication between units of an automation device 1. The data interface 3 is used for transferring the device information DAT to the display unit 2 and for controlling a display of the transferred device information DAT on the display unit 2. The controlling of the display unit 2 can be done by the processing unit 4 of the automation device 1, for example. I.e., the processing unit 4 of the automation device 1 provides the device information DAT as well as the control signals for displaying the device information DAT on the display unit 2. The data interface 3 can therefore be initialized, when the automation device 1 is turned on and supplied with power for the first time, e.g., during a test phase, in particular during end of the line testing at the production site. A transfer of device information DAT to the display unit 2 is established during this first startup. I.e., the device information, like e.g., parameter settings, firmware version, fieldbus address, errors occurring, status information, etc., can be transferred via the data interface 3 to the display unit 2. The device information DAT shown on the display unit 2 is thus updated, as long as the automation device 1 and the display unit 2 are supplied with power. In particular, the device information DAT shown on the display unit 2 can be cyclically updated. A user, like a service technician, for example, is then always provided with most recent or latest device information DAT.

When the power supply is switched off or interrupted, for example, after finishing the test phase, because of a shut down the automation device 1, because of the kill switch being hit or because of a failure of power supply, the display unit 2 is set up to maintain a currently displayed device information DAT as a remanent image. This remanent image, showing the most recent device information DAT transferred to the display unit 2, may also include an information on errors, which occurred at last before the kill switch being hit or the power failure, for example. Thus, the user or service technician can be supported, in particular when troubleshooting issues. In case the power supply of the automation device 1 was switched off on purpose, e.g. after finishing the test phase or end of the line testing, the user or service technician can already read the device information DAT (e.g. fieldbus address, firmware version, etc.) shown by the remanent image on the display unit 2, for example, when unboxing, installing and commissioning the automation device 1 at the customer site.

The remanent image is maintained on the display unit 2, at least until the power supply of the automation device 1 is restored again. With the power supply restored, the display unit 2 can be provided with new device information DAT via the data interface 3 and the displayed device information DAT shown on the display unit 2 can be updated again. But, it is also possible to further maintain the remanent image on the display unit 2, even after the power supply has been restored again, and to trigger an update of the displayed information e.g., manually. Thus, the device information before a power failure or before the power fail may be still available, if a service person arrives at the automation device 1 after restoration of the power supply. The service person then can see the last information before the power failure.

The display unit 2 may use electronic paper technology for displaying the device information DAT and especially for keeping a remanent image of the device information DAT, which was at last shown before turning off the power supply or before a power failure, without existing power supply. Various display technologies may be used to realize the display unit 2 as an E-paper display. The display unit 2 may be realized as Gyricon display, electrophoretic or microencapsulated electrophoretic display, electrowetting display, electro fluidic display, plasmonic electronic displays, interferometric modulator display and so on.

Other technologies being applied to electronic paper also include modification of liquid crystal displays, which can retain an image without power, like bistable liquid crystal displays, in particular ferroelectric liquid crystal displays or cholesteric liquid-crystal displays. These technologies can also be used to realize the display unit 2.

## Claims

1. An automation device (1) comprising a display unit (2) for visually displaying device information (DAT) of the automation device (1), the display unit (2) being connected via a data interface (3) to a processing unit (4) of the automation device (1), to transfer the device information (DAT) to be displayed to the display unit (2) via the data interface (3), ***characterized in that*** the display unit (2) is set up to display device information (DAT) transferred via the data interface (3), ***and in that*** the display unit (2) is furthermore set up to maintain a currently displayed device information (DAT) as a remanent image, when the power supply of the automation device (1) is turned off and/or fails,.

2. The automation device (1) according to claim 1, ***characterized in that*** the display unit (2) uses electronic paper technology for displaying the device information.

3. The automation device (1) according to claim 1 or 2, ***characterized in that*** the display unit (2) is set up to transfer and/or display the device information (DAT) during an existing power supply of the automation device (1).

4. The automation device (1) according to one of the claims 1 to 3, ***characterized in that*** the display unit (2) is set up to update the displayed device information (DAT) cyclically during an existing power supply of the automation device (1).

5. The automation device (1) according to one of the claims 1 to 4, ***characterized in that*** the display unit (2) is set up to maintain the remanent image of the displayed device information (DAT), at least until the power supply of the automation device (1) is restored again.

6. The automation device (1) according to one of the claims 1 to 5, ***characterized in that*** the automation device (1) has a housing (5), wherein the display unit (2) is integrated into a wall of the housing (5) or the display unit (2) is either arranged on a wall of the housing (5) or in a window formed in a wall of the housing (5).

7. The automation device (1) according to one of the claims 1 to 6, ***characterized in that*** the automation device (1) is an automation device (1) with a fieldbus connection.

8. The automation device (1) according to claim 7, ***characterized in that*** the device information (DAT) displayed on the display unit (2) at least comprises a fieldbus address of the automation device (1).

9. The automation device (1) according to one of the claims 1 to 8, ***characterized in that*** the device information (DAT) displayed on the display unit (2) furthermore comprises a current status of the automation device (1) and/or a firmware version of the automation device (1).

10. The automation device (1) according to one of the claims 1 to 9, ***characterized in that*** the device information (DAT) displayed on the display unit (2) also comprises an information on errors occurred at last before a power failure.

11. The automation device (1) according to one of the claims 1 to 10, ***characterized in that*** the data interface (3) is initialized, when the automation device (1) and/or the display unit (2) are turned on and supplied with power for the first time, in particular during a test phase of the automation device (1).
